# EUROPEAN PATENT SPECIFICATION

(11) **EP 2 833 171 B1**
(45) Date of publication and mention of the grant of the patent: **29.04.2020**
(21) Application number: 13769512.8
(22) Date of filing: 27.03.2013
(51) Int. Cl.: G02B 5/20, G02F 1/1335, H01L 51/50, H05B 33/12, H05B 33/14

(54) **METHOD FOR PRODUCING A DISPLAY COLOR FILTER**
VERFAHREN ZUR HERSTELLUNG EINES FARBFILTERS FÜR BILDSCHIRM
MÉTHODE DE PRODUCTION D'UN FILTRE DE COULEUR D'ÉCRAN D'AFFICHAGE

(30) Priority: 28.03.2012 JP 2012074909
(43) Date of publication of application: 04.02.2015
(73) Proprietor: Toppan Printing Co., Ltd., Tokyo 110-0016 (JP)
(72) Inventor: KINOSHITA, Kayo, Tokyo 110-0016 (JP); MATSUMOTO, Yuichi, Tokyo 110-0016 (JP)
(74) Representative: TBK
(86) International application number: PCT/JP2013/059053
(87) International publication number: WO 2013/146903

(56) References cited:
- JP-A- H 085 832
- JP-A- H0 921 909
- JP-A- 2001 066 414
- JP-A- 2001 166 122
- JP-A- 2002 243 933
- JP-A- 2004 226 517
- Anonymous: "IUPAC Gold Book - solubility", , 24 February 2014 (2014-02-24), XP055216139, Retrieved from the Internet: URL:http://goldbook.iupac.org/S05740.html [retrieved on 2015-09-25]

## Description

### [Technical Field]

This invention relates to a color filter for a display such as of liquid crystal, organic or inorganic EL, or an electronic paper, especially the color filter produced by an ink jet printing method.

### [Background Art]

In a display system, using a color filter with the purpose of color display, reducing a reflectance, improvement of contrast and control of spectroscopic characteristics has been a useful procedure. This color filter used for a display has fine color pixels. The methods for forming pixels of this color filter, as the methods used heretofore practically, include a photolithography method, a printing method, and the like.

For example, in a photolithography method, the steps, coating-> light exposure of a pattern-> development -> thermal curing, are repeated. This method is excellent in quality, while production processes take a long time and production equipment therefore is large-scale. In addition, cost is high, because photo masks are necessary depending on the respective patterns in light exposure of a pattern, and because efficiency in use of materials is low since materials other than a pattern are removed in a development step.

In a printing method, processes thereof can be shortened, compared to a photolithography method. However, since plates are necessary depending on the respective patterns, cost is high.

On the other hand, an ink jet printing method is a printing technology represented such as in a printer of peripheral devices of a personal computer. In recent years, this method is expected to be developed for application to industrial uses in various fields. Advantages thereof are mainly the following four points.

Firstly, a necessary amount can be pattern-printed on necessary portions. That is, it is on-demand printing. Therefore, only the minimum amount of materials is consumed, and environmental load is extremely small.

As the second point, data made in a personal computer can directly be printed. Accordingly, indirect members such as masks or plates are not necessary, which enables cost-cutting and shortening of processes.

As the third point, there is no need for steps such as of development and etching. Therefore, characteristics of materials are not deteriorated owing to chemical effects.

As the fourth point, it is contactless printing. Accordingly, contact with an original plate does not damage the substrate.

Against this background, many techniques for applying ink jet printing methods to production of a color filter have been suggested. The color filter is a member for a display. Therefore, transparency is indispensable for the color filter, and glass or films are used as substrates of the color filter. However, by an ink jet printing method, it is difficult to form pixels directly on such a substrate. Accordingly, generally, a separator wall or an ink fixing layer is provided on the substrate.

A separator wall type, in a color filter for a liquid crystal display, is a method where a general black matrix between pixels serves as a wall and pixel ink is provided by an ink jet printing method at an open portion on the inside thereof. An ink fixing layer type is a method where a transparent resin layer to absorb solvent in ink is provided and pixel ink is applied thereon. For forming color filters corresponding to the diversification of displays, the latter, the ink fixing layer type, is more excellent.

Many techniques relevant to this ink fixing layer type have been suggested. For example, in Patent literature 1 (Japanese patent application publication 2001-66414), Patent literature 2 (Japanese patent application publication 2001-66415), Patent literature 3 (Japanese patent application publication 2001-166122) and Patent literature 4 (Japanese patent application publication 2003-29020), there is described a method where an ink fixing layer consisting of a hot-melt curing resin composition is formed on a substrate having a black matrix, followed by controlling wettability of inks at opening portions and light shielding portions by light exposure with a mask, thereafter coloring the open portions, melting and curing by a heat treatment to form pixels.

These methods, however, need masks for light exposure as indirect members, and therefore cannot sufficiently show the advantage of the ink jet printing method in cost.

In Patent literature 5 (Japanese patent application publication 2001-66413) and Patent literature 6 (Japanese patent application publication 2001-66413), there is supposed a method where an ink fixing layer is formed on a substrate having a black matrix, followed by controlling wettability of inks at opening portions and light shielding portions by light exposure with a mask, thereafter coloring the open portions, thermally-curing to form pixels.

In this case, although color mixture on a boundary of pixels is a concern because there is no absorbability difference of ink, there are few problems in display owing to the presence of the black matrix. If there is no black matrix, however, such a problem cannot be avoided.

### [Summary of Invention]

### [Technical Problem]

The problem to be resolved by the present invention is a provision of a method for producing a color filter for a display which has excellent accuracy in pixel shape, uniformity of pixel color density and environment resistance by providing an ink fixing layer on a transparent substrate and controlling absorbability of a color ink on the ink fixing layer in a color filter to be produced by an ink jet printing method.

### [Solution to Problem]

A color filter for a display produced by a first embodiment of the present invention is characterized in that: the color filter comprises a transparent substrate, an ink fixing layer formed on at least one surface of the transparent substrate and made from a synthetic resin, and a color layer made from a color ink by a ink jet printing method at an arbitrary position on the ink fixing layer; the color ink contains 70 % or more of a solvent, the solvent having boiling point of 150°C or more; and solubility of the ink fixing layer into the solvent is 0.5-5 %.

A color filter for a display produced by a second embodiment of the present invention is, in the first embodiment, characterized in that the solvent in the color ink consists of at least one solvent chosen from aliphatic esters, polyhydric alcohol and derivatives thereof.

The color filter for a display produced by a third embodiment of the present invention is, in the first embodiment, characterized in that contact angle of the surface of the ink fixing layer to the solvent in the color ink is 30°-60°.

The color filter for a display produced by a fourth embodiment of the present invention is, in the first embodiment, characterized in that the transparent substrate is made from glass or a resin film, and has thereon at least two alignment marks for patterning.

The color filter for a display produced by a fifth embodiment of the present invention is, in the first embodiment, characterized in that: the moisture transmission rate of the transparent substrate is 0.1 g/m²/24hr or less; and dimension change in a heating treatment at 100°C for ten minutes is 100 ppm or less.

The color filter for a display produced by a sixth embodiment of the present invention is, in the first embodiment, characterized in that: the display is a display where a substrate to form the color filter is previously provided; the ink fixing layer is formed on a display surface of the display; the color layer is made from the color ink by a ink jet printing method at a position corresponding to a display pixel portion on the ink fixing layer.

### [Advantageous Effects of Invention]

Owing to the color filter for a display produced by the first embodiment, the color filter having excellent stability in shape and uniformity of pixel color density can be obtained. If the solubility is under 0.5%, because permeability of the ink solvent component into the ink fixing layer is poor, uniformity of pixel color density lowers significantly. If the solubility is over 5 %, the permeability is high and degree of bleeding is large, which can cause defects such as color mixture of pixels to occur.

Owing to the color filter for a display produced by the second embodiment, the color filter having excellent stability in shape and uniformity of pixel color density can be obtained. If the boiling point is under 150 °C, dryness is significantly large in the vicinity of a nozzle of an ink jet head, and this causes faults such as a nozzle clogging to be provoked. Therefore, it is not preferred.

Owing to the color filter for a display produced by the third embodiment, the color filter having excellent stability in shape and uniformity of pixel color density can be obtained. If the contact angle of the surface of the ink fixing layer and the solvent in the color ink is under 30°, because the degree of bleeding on the ink fixing layer is significantly large, color mixture between adjacent pixels occurs. If the contact angle is over 60°, poor wettability causes uniformity of pixel color density to lower significantly.

Owing to the color filter for a display the fourth embodiment, the color filter which is excellent in transparency and positional accuracy can be formed. If the number of the provided alignment marks is one, since the substrate cannot be horizontally placed, positional accuracy in printing cannot be secured.

Owing to the color filter for a display produced by the fifth embodiment, the color filter having excellent stability in dimension can be formed. If the dimension change is over 100 ppm, securement of alignment accuracy when an opposite substrate such as a TFT is laminated thereto becomes impossible.

Owing to the color filter for a display produced by the sixth embodiment, the color filter having excellent stability in shape and uniformity of pixel color density can be obtained.

### [Brief Description of Drawings]

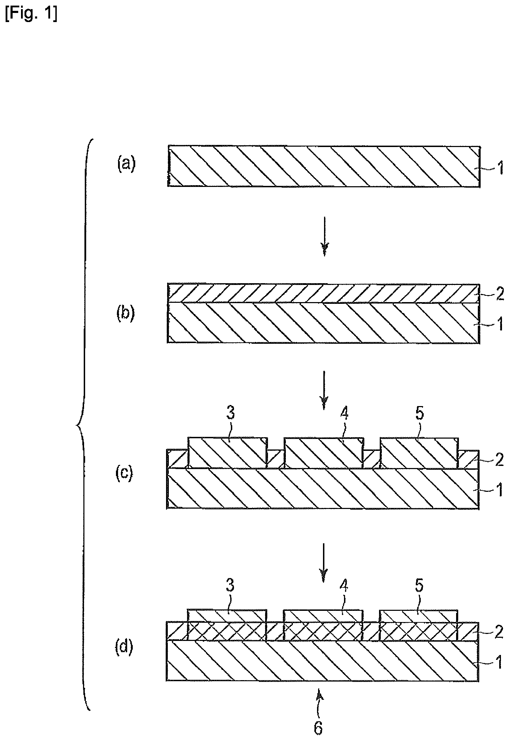

[Figure 1] is a longitudinal sectional side view for explaining a producing method of a color filter according to an embodiment of the present invention in a process sequence.

### [Description of Embodiments]

A color filter for a display produced by an embodiment of the present invention is now described, referring to the drawings.

Fig. 1 shows a method for producing the color filter according to this embodiment in a process sequence. At first, as shown in (a) of Fig. 1, a transparent substrate 1 is prepared. Subsequently, as shown in (b) of Fig. 1, a transparent ink fixing layer 2 is formed on the transparent substrate 1. Next, as shown in (c) of Fig. 1, a red pixel 3, a green pixel 4 and a blue pixel 5 are formed at the respective specific positions on the ink fixing layer 2 with color inks by an ink jet printing method. At this time, the ink fixing layer 2 is dissolved into a solvent of the color ink and swells, thereby the color ink is fixed. By the aforementioned process, as shown in (d) of Fig. 1, the color filter 6 having excellent pixel shapes and color material fixing properties is formed.

This color filter 6 for a display of this embodiment has the transparent substrate 1, the ink fixing layer 2 made of synthetic resin and formed on at least one surface of the transparent substrate 1, and a color layer (red pixel 3, green pixel 4 and blue pixel 5) formed at given positions on the ink fixing layer 2 by an ink jet printing method with color inks. Here, the display may be a display where the substrate to form the color filter 6 is previously embedded, the ink fixing layer 2 may be formed on a display surface of the display, and the color layer may be formed on positions corresponding to display pixel portions on the ink fixing layer 2.

As the transparent substrate 1 used for this embodiment, one having sufficient strength, flatness, heat-resistance and optical transparency and the like is preferred. For example, there can be a transparent glass substrate ordinarily used as a substrate of a color filter, such as alkali-free glass or soda glass.

As the transparent substrate 1, there can also be used a film substrate made such as of polyethylene terephthalate, polyethylene naphthalate, polymethylmethacrylate, polycarbonate, polysulfone, polyethersulfone, polycycloolefin, acrylic cross-linked resins, epoxy cross-linked resins or unsaturated polyester cross-linked resins. In addition, as the transparent substrate 1, it is preferred to use resin and inorganic material in combination, since a linear expansion coefficient thereof can be reduced.

The moisture transmission rate of the transparent substrate is preferably 0.1 g/m²/24hr or less. If the moisture transmission rate of the transparent substrate is over 0.1 g/m²/24hr, dimension change due to water absorption of the substrate occurs at of the order of hundreds ppm, which causes dimension accuracy to lower significantly, therefore it is not preferable. It is preferred that dimension change in a heat treatment at 100°C for ten minutes is 100 ppm or less. If the dimension change is over 100 ppm, securement of alignment accuracy when an opposite substrate such as a TFT is laminated thereto becomes impossible.

The materials of the ink fixing layer 2 according to this embodiment contain resin as a primary component, solvent, and as needed, organic or inorganic fine particles and the like.

The materials of the ink fixing layer 2 is required to have performances in that it is transparent, it has excellent fixing properties of color material in received ink, there is no change in color or discoloration, it has resistance properties, and the like. The representative materials of this ink fixing layer 2 can include, for example, acrylic resins such as polyacrylic acid ester and polymethacrylic acid ester. However, as the materials of the ink fixing layer 2, materials such as of polyester resin, polyurethane resin and polyvinyl resin may be used as long as they satisfy the aforementioned required performances.

It is preferred that the solubility of the ink fixing layer 2 to an ink solvent component is 0.5-5%. If the solubility is under 0.5%, because permeability of the ink solvent component into the ink fixing layer 2 is poor, uniformity of pixel color density lowers significantly. If the solubility is over 5 %, the permeability is high and degree of bleeding is large, which can cause defects such as color mixture of pixels to occur.

It is preferred that a contact angle of the ink solvent component on the coating surface of the ink fixing layer 2 is 30-60°. If the contact angle is under 30°, because the degree of bleeding on the ink fixing layer 2 is significantly large, color mixture between adjacent pixels occurs. If the contact angle is over 60°, poor wettability causes uniformity of pixel color density to lower significantly. In addition to this characteristic, when the diameter of discharged droplet during ink jet printing is defined as D1 µm and diameter of the droplet when landing on the ink fixing layer 2 is defined as D2 µm, it is preferred to satisfy the formula 1.0×D1≤D2≤1.5xD1. If D2<1.0×D1 is satisfied, because the wettability on the ink fixing layer 2 is poor, uniformity of pixel color density lowers significantly, therefore it is not preferred. If D2>1.5×D1 is satisfied, because the degree of bleeding on the ink fixing layer 2 is significantly large, color mixture between the adjacent pixels occurs, therefore it is not preferred.

The above ink solvent, for example, consists of fatty ester, polyhydric alcohol and derivative thereof whose boiling point is 150°C or more. Color ink preferably contains 70% or more of a solvent whose boiling point is 150°C or more. If the content percentage is under 70 %, the solvent is likely to dry in the vicinity of a nozzle of an ink jet head, which causes printing faults due to nozzle clogging to occur, therefore it is not preferable.

It is preferred that fracture elongation of the coating layer of the ink fixing layer 2 is 300-600 %. If the fracture elongation is under 300 %, permeability of the ink solvent component into the ink fixing layer 2 is poor, uniformity of pixel color density lowers significantly. If the fracture elongation is over 600 %, the permeability is high and degree of bleeding is large, which causes defects such as color mixture of pixels to be provoked.

The solvent of the image fixing layer 2 is made to be a coating solution which is 10-50 weight % solution using one type of or a mixed solvent of two or more types of water, ethanol, isopropyl alcohol, acetone, methyl ethyl ketone, methyl isobutyl ketone, ethyl acetate, toluene, xylene, ethyl cellosolve, ethyl cellosolve acetate, diglyme, cyclohexanone and the like. A solvent system which can dry at approximately 100 °C is preferred.

To the ink fixing layer 2, depending on purposes, a resin other than the above, a surface acting agent, an ultraviolet absorber, an antioxidant, a pH adjuster, an antifoam and other additives may arbitrary be added without departing from the performances.

The thickness of the ink fixing layer 2 is approximately 1-20 µm, preferably approximately 2-10 µm. The ink fixing layer may be formed by coating at least one surface of the support with a coating solution where the above main agent and curing agent are mixed by an arbitrarily equivalent ratio using a publicly known coating means such as a gravure coat, a roll coat and a wire bar coat.

The color ink in this embodiment is made from a color pigment, a resin, a dispersant, a solvent and the like.

Specific examples of the pigment used as a coloring agent can include Pigment Red9, 19, 38, 43, 97, 122, 123, 144, 149, 166, 168, 177, 179, 180, 192, 215, 216, 208, 216, 217, 220, 223, 224, 226, 227, 228, 240, Pigment Blue 15, 15:6, 16, 22, 29, 60, 64, Pigment Green7, 36, Pigment Red 20, 24, 86, 81, 83, 93, 108, 109, 110, 117, 125, 137, 138, 139, 147, 148, 153, 154, 166, 168, 185, Pigment Orange36, Pigment Violet23, or the like. However, they are not limited to these. Further, the pigment may be used by mixing two or more types thereof for obtaining desired hues.

As types of solvents used in the color ink, ones having a surface tension range in ink jet printing which is adequate and 35 mN/m or less, and those whose boiling point is 150°C or more are preferred. The surface tension over 35 mN/m causes a significant negative effect on stability of dot shapes in ink jet ejection. If the boiling point is under 150 °C, dryness is significantly large in the vicinity of a nozzle of an ink jet head, and this causes faults such as a nozzle clogging to be provoked.

Specifically, the solvents can include ethylene glycol dibutyl ether, ethylene glycol monohexyl ether, ethylene glycol monoacetate, diethylene glycol monomethyl ether, diethylene glycol monomethyl ether acetate, diethylene glycol dimethyl ether, propylene glycol, propylene glycol monobutyl ether, dipropylene glycol monomethyl ether, dipropylene glycol monoethyl ether, 3,4-hexylene glycol or the like. However, it is not limited to these; a solvent which satisfies the above requirements can be used. As needed, two or more types of solvents may be mixed and used.

As the color ink in this embodiment, there is used casein, gelatin, polyvinylalcohol, carboxymethyl acetal, polyimide resin, acrylic resin, epoxy resin, melamine resin or the like, it is arbitrarily chosen in relation to pigments. If heat resistance or light resistance is required, acrylic resin is preferred.

In order to advance dispersion of the pigment into the resin, a dispersant may be used. The dispersant can include, for example polyoxyethylene alkyl ether or the like as a non-ionic surface acting agent, for example sodium alkylbenzene sulfonic acid, salt of polyaliphatic acid, fatty acid salt alkyl phosphate salt, tetraalkylammonium salt or the like as an ionic surface acting agent, aside from this, an organic pigment derivative, polyester or the like. Regarding the dispersant, one type may be used singularly, or two or more types may be mixed and used. Temporal stability, drying property and the like other than solubility are required of the solvent, the solvent is arbitrarily chosen in relation to the pigment and the resin.

In this embodiment, the transparent substrate 1 has at least two or more alignment marks for patterning thereon. That is because, if the number of the provided alignment mark is one, the coordinates on the substrate cannot be recognized, and thereby positional accuracy in printing cannot be secured.

The materials of the alignment mark formed on the transparent substrate 1 can include a black resin composition containing a black light shielding material used as a black matrix material, a dispersant, a resin and a solvent mainly, or the like. For example, a black resin composition where photopolymerizable monomer, photopolymerization initiator or the like is mixed to provide light-sensitivity is preferred.

The black light shielding material includes a black pigment, a black dye, an inorganic material or the like, an organic pigment, carbon black, aniline black, graphite, titanium oxide, iron black and the like are mixed and used.

The dispersant can include, for example polyoxyethylene alkyl ether or the like as a non-ionic surface acting agent, for example sodium alkylbenzene sulfonic acid, salt of polyaliphatic acid, fatty acid salt alkyl phosphate salt, tetraalkylammonium salt or the like as an ionic surface acting agent, aside from this, an organic pigment derivative, polyester or the like. Regarding the dispersant, one type may be used singularly, or two or more types may be mixed and used.

The solvents can include, for example, toluene, xylene, ethyl cellosolve, ethyl cellosolve acetate, diglyme or cyclohexanone. In view of coatability of the black resin composition, dispersion stability and the like, the solvent can be arbitrarily chosen to be used.

The black matrix in this embodiment can also be formed by forming a resist pattern by photolithography on a light shielding film formed by vapor deposition or sputtering and thereafter etching it using this resist pattern as a mask.

As the materials of the light shielding film, there can be used a vapor-deposited film or a sputter film of metallic Cr or Cr base alloy. The light shielding film made of metallic Cr or Cr base alloy has excellent corrosion resistance and light shielding effect. If the reflectance of the light shielding film is high, reflected light from outside lowers the contrast of a displayed image. Therefore, for making images more visible, a low reflecting film consisting of a compound thin film such as of CrO or CrN can also be formed between the base and the light shielding film.

The color filter in this embodiment, after forming pixels, with the aim of improving the resistance properties, can be subjected to a curing treatment by energy such as of heat, light, electron beam or the like. For example, a reactive substituent group may be introduced in the components of the ink fixing layer 2, and a curing agent such as epoxy or isocyanate may be used simultaneously to cure.

As ink jet printers to be used, there are a piezo conversion type and a thermal conversion type which are different in discharging method of an ink, especially a piezo conversion type is favorable. A printer which is approximately 1-100 KHz in atomization frequency of ink, approximately 5-80 µm in nozzle diameter, has three heads and 100-500 nozzles embedded in each head is favorable. Further, as needed, after forming the color layer, curing such as heating may be performed.

### Example

Hereinafter, Examples are made for explaining the present invention in further detail. However, the present invention is not limited only to these examples.

### <Example 1>

30 parts methyl methacrylate, 20 parts 2-hydroxyethylmethacrylate, 45 parts vinyl pyrrolidone and 5 parts polyethylene glycol dimethacrylate (n=9) were fed into a four-necked flask having a stirrer, a nitrogen feed pipe and a reflux condenser pipe. Further, 240 parts isopropyl alcohol, 140 parts water and 20 parts γ-butyrolactone were added to the flask and dissolved uniformly. Thereafter, it was stirred on an oil bath under a nitrogen atmosphere. To this, 0.5g of α', α- azobisisobutyronitrile was added, thereby initiating polymerization. Heating stirring was continued on an oil bath at 60°C for six hours. Thereby, a colorless and sticky polymer solution A was obtained. After that, it was applied by coating such that the thickness was 5 µm, followed by drying for three minutes at 80°C, thereby the ink fixing layer 2 was formed.

Preparation of the color inks; a dispersion was prepared by kneading a red pigment (C.I.Pigment Red 177) with solid content of 20 % in diethylene glycol monoethyl ether acetate (boiling point 210°C). 30 parts this dispersion, 15 parts melamine resin (MW-22, produced by Sanwa Chemical) and 55 parts diethylene glycol monoethyl ether acetate were mixed to obtain a red ink. In a similar manner, a blue ink and a green ink were obtained using a blue pigment (Pigment Blue 15) and a green pigment (Pigment Green7), respectively.

Formation of the color filter; droplets were printed on the glass substrate on which the ink fixing layer 2 is formed by coating, with a ink jet printer having an ink jet head (manufactured by Seiko Instruments Inc.) which is 12 pl in discharge amount and 180 dpi in nozzle resolution, using the above each color ink of respective colors. Ink absorbability was confirmed by the size. Thereafter, nine drops of three drops (50 µm in pitch) in column and three drops (50 µm in pitch) in row were printed such that one pixel was 200 µm square, and the state of the pixel was confirmed by the size thereof. As described above, the color layers 3, 4, 5 were formed to obtain the color filter 6.

### <Example 2>

30 parts methyl methacrylate, 20 parts methacrylic acid amide, 45 parts vinyl pyrrolidone and 5 parts polypropylene glycol dimethacrylate (n=7) were fed into a four-necked flask having a stirrer, a nitrogen feed pipe and a reflux condenser pipe. Further, 280 parts isopropyl alcohol, 100 parts water and 20 parts γ-butyrolactone were added to the flask and dissolved uniformly. Thereafter, it was stirred on an oil bath under a nitrogen atmosphere. To this, 0.5 g of α', α'-azobisisobutyronitrile was added, thereby initiating polymerization. Heating stirring was continued on an oil bath at 60°C for six hours. Thereby, a colorless and sticky polymer solution B was obtained. After that, it was applied by coating such that the thickness was 5 µm, followed by drying for three minutes at 80°C, thereby the ink fixing layer 2 was formed.

Preparation of the color ink and formation of the color filter were carried out in the same manner as Example 1.

### <Comparative example 1>

60 parts methyl methacrylate, 20 parts ethylacrylate, 15 parts vinyl pyrrolidone and 5 parts neopentyl glycol dimethacrylate were fed into a four-necked flask having a stirrer, a nitrogen feed pipe and a reflux condenser pipe. Further, 250 parts isopropyl alcohol, 130 parts water and 20 parts γ-butyrolactone were added to the flask and dissolved uniformly. Thereafter, it was stirred on an oil bath under a nitrogen atmosphere. To this, 0.5 g of α, α'-azobisisobutyronitrile was added, thereby initiating polymerization. Heating stirring was continued on an oil bath at 60°C for six hours. Thereby, a colorless and sticky polymer solution C was obtained. After that, it was applied by coating such that the thickness was 5 µm, followed by drying for three minutes at 80°C, thereby the ink fixing layer 2 was formed.

Preparation of the color ink and formation of the color filter were carried out in the same manner as Example 1.

### <Comparative example 2>

60 parts methyl methacrylate, 20 parts ethylacrylate and 20 parts vinyl pyrrolidone were fed into a four-necked flask having a stirrer, a nitrogen feed pipe and a reflux condenser pipe. Further, 250 parts isopropyl alcohol, 130 parts water and 20 parts γ-butyrolactone were added to the flask and dissolved uniformly. Thereafter, it was stirred on oil bath under a nitrogen atmosphere. To this, 0.5 g of α, α'-azobisisobutyronitrile was added, thereby initiating polymerization. Heating stirring was continued on oil bath at 60°C for six hours. Thereby, a colorless and sticky polymer solution C was obtained. After that, it was applied by coating such that the thickness was 5 µm, followed by drying for three minutes at 80°C, thereby the ink fixing layer 2 was formed.

Preparation of the color ink and formation of the color filter were carried out in the same manner as Example 1.

### <Comparative example 3>

Preparation of the color inks; a dispersion was prepared by kneading a red pigment (C.I.Pigment Red 177) with solid content of 20 % in propylene glycol monomethyl ether (boiling point 120°C). 30 parts this dispersion, 15 parts melamine resin (MW-22, produced by Sanwa Chemical) and 55 parts propylene glycol monomethyl ether were mixed to obtain a red ink. In a similar manner, a blue ink and a green ink were obtained using a blue pigment (Pigment Blue 15) and a green pigment (Pigment Green7), respectively.

Preparation of the ink fixing layer and formation of the color filter were carried out in the same manner as in Example 1.

The following Table 1 shows characteristics of the color filters described in above Examples 1-2 and Comparative example 1-3. Since ink was not discharged, Comparative example 3 did not reach the subsequent print evaluation and so on.

**[Table 1]**

| | Ink discharging property | Solubility | Contact angle | Ink absorbability | Pixel size | Fracture elongation |
|---|---|---|---|---|---|---|
| Example 1 | ○ | ○ | ○ | ○ | ○ | ○ |
| Example 2 | ○ | ○ | ○ | ○ | ○ | ○ |
| Comparative example 1 | ○ | X | X | X | X | Δ |
| Comparative example 2 | ○ | Δ | Δ | Δ | Δ | Δ |
| Comparative example 3 | X | - | - | - | - | - |

Details of evaluation method in above Table 1 are described below.

### <Ink discharging property>

The discharging state of the color ink from an ink jet head was observed, and evaluated according to the following criteria of judgment.

○; The number of discharging nozzles 95% or more
Δ; The number of discharging nozzles 80-95%
X; The number of discharging nozzles 80% or less

### <Solubility>

After the ink fixing layer was formed on the release film, the released ink fixing film was cut into arbitrary size. Thereafter, the solubility into the color ink solvent was measured, and evaluated according to the following criteria.

○; Solubility 0.5-5.0%
Δ; Solubility 0.3-0.5%, or 5.0-10%
X; 0.3% or less, or 10% or more

### <Contact angle>

After the ink fixing layer was formed on the glass substrate, the contact angle of the color ink solvent as a solvent on the surface of the ink fixing layer was measured using a dynamic surface tensiometer (ZR-21 model) produced by Kyowa Interface Science, and evaluated according to the following criteria.

○; Contact angle 30-60°
Δ; Contact angle 25-30°, or 60-70°
X; Contact angle 25° or less, or 70° or more

### <Ink absorbability>

The size of the droplet printed on the ink fixing layer was measured by microscope observation, and evaluated according to the following criteria.

○; 30-45 µm
Δ; 25-30, or 45-50 µm
X; 25 µm or less, 50 µm or more

### <Pixel size>

The size of the pixel printed on the ink fixing layer was measured by microscope observation, and evaluated according to the following criteria.

○; 200 µm ± 10%
Δ; 200 µm ± from not less than 10% to less than 20%
X; 200 µm ± 20% or more

### <Fracture elongation>

The fracture elongation was measured according to a measurement method based on JIS K-6301, and evaluated according to the following criteria.

○; Fracture elongation 300-600%
Δ; Fracture elongation under 300%
X; Fracture elongation 600% or more

### [Industrial Applicability]

In the present invention, an ink fixing layer is provided on a transparent substrate, and pixels are formed by an ink jet printing method, thereby a color filter for a display having excellent stability in shape and uniformity of pixel color density can be obtained. As industrial applications, there can be a liquid crystal display, an electronic paper and a display such as of organic and inorganic EL.

## Claims

1. A method for producing a color filter (6) for a display, comprising preparing a transparent substrate (1);
forming a transparent ink fixing layer (2) on the transparent substrate (1);
ink jet printing at an arbitrary position on the ink fixing layer (2) to form a color layer made from a color ink;
wherein
the color filter (6) comprises
the transparent substrate (1),
the ink fixing layer (2) formed on at least one surface of the transparent substrate (1) and made from a synthetic resin, and
the color layer,
wherein the method for producing a color filter (6) is **characterized in that**
the color ink contains 70 % or more of a solvent having boiling point of 150°C or more; and that
the solubility of the ink fixing layer (2) into the solvent is 0.5-5%;
wherein the solubility of the ink fixing layer (2) into the solvent is measurable after the ink fixing layer (2) has been formed.

2. The method for producing a color filter (6) for a display defined in claim 1, **characterized in that** the solvent in the color ink consists of at least one solvent chosen from aliphatic esters, polyhydric alcohol and derivatives thereof.

3. The method for producing a color filter (6) for a display defined in claim 1, **characterized in that** contact angle of the surface of the ink fixing layer (2) to the solvent in the color ink is 30°-60°.

4. The method for producing a color filter (6) for a display defined in claim 1, **characterized in that** the transparent substrate (1) is made from glass or a resin film, and has thereon at least two alignment marks for patterning.

5. The method for producing a color filter (6) for a display defined in claim 1, **characterized in that**:
the moisture transmission rate of the transparent substrate (1) is 0.1 g/m²/24hr or less; and
dimension change in a heating treatment at 100°C for ten minutes is 100 ppm or less.

6. The method for producing a color filter (6) for a display defined in claim 1, **characterized in that**:
the display is a display where a substrate to form the color filter is previously provided;
the ink fixing layer (2) is formed on a display surface of the display;
the color layer is made from the color ink by a ink jet printing method at a position corresponding to a display pixel portion on the ink fixing layer (2).

## Patentansprüche

1. Verfahren zum Herstellen eines Farbfilters (6) für eine Anzeigevorrichtung, umfassend
Herstellen eines transparenten Substrats (1);
Bilden einer transparenten Tintenfixierschicht (2) auf dem transparenten Substrat (1);
Tintenstrahldrucken an einer beliebigen Position auf der Tintenfixierschicht (2), um eine aus einer Farbtinte hergestellte Farbschicht zu bilden;
wobei
der Farbfilter (6) umfasst
das transparente Substrat (1),
die Tintenfixierschicht (2) gebildet an zumindest einer
Oberfläche des transparenten Substrats (1) und hergestellt aus einem synthetischen Harz, und
die Farbschicht,
wobei das Verfahren zum Herstellen eines Farbfilters (6) **dadurch gekennzeichnet ist, dass**
die Farbtinte 70 % oder mehr eines Lösungsmittels aufweisend einen Siedepunkt von 150°C oder mehr enthält; und dass
die Löslichkeit der Tintenfixierschicht (2) in dem Lösungsmittel 0,5-5 % ist;
wobei die Löslichkeit der Tintenfixierschicht (2) in dem Lösungsmittel messbar ist nachdem die Tintenfixierschicht (2) gebildet wurde.

2. Verfahren zum Herstellen eines Farbfilters (6) für eine Anzeigevorrichtung definiert in Anspruch 1, **dadurch gekennzeichnet, dass** das Lösungsmittel in der Farbtinte aus zumindest einem Lösungsmittel ausgewählt aus aliphatischen Estern, mehrwertigem Alkohol und Derivativen davon besteht.

3. Verfahren zum Herstellen eines Farbfilters (6) für eine Anzeigevorrichtung definiert in Anspruch 1, **dadurch gekennzeichnet, dass** der Kontaktwinkel der Oberfläche der Tintenfixierschicht (2) zu dem Lösungsmittel in der Farbtinte 30°-60° ist.

4. Verfahren zum Herstellen eines Farbfilters (6) für eine Anzeigevorrichtung definiert in Anspruch 1, **dadurch gekennzeichnet, dass** das transparente Substrat (1) hergestellt ist aus Glas oder einem Harzfilm und aufweist darauf zumindest zwei Ausrichtungsmarkierungen zur Strukturierung.

5. Verfahren zum Herstellen eines Farbfilters (6) für eine Anzeigevorrichtung definiert in Anspruch 1, **dadurch gekennzeichnet, dass**:
die Feuchtigkeitsübertragungsrate des transparenten Substrats (1) 0,1g/m²/24 Stunden oder weniger ist; und
die Dimensionsänderung in der Wärmebehandlung bei 100°C für zehn Minuten 100 ppm oder weniger ist.

6. Verfahren zum Herstellen eines Farbfilters (6) für eine Anzeigevorrichtung definiert in Anspruch 1, **dadurch gekennzeichnet, dass**:
die Anzeigevorrichtung eine Anzeigevorrichtung ist, bei der zuvor ein Substrat zur Bildung des Farbfilters bereitgestellt ist;
die Tintenfixierschicht (2) auf der Anzeigevorrichtungsoberfläche der Anzeigevorrichtung gebildet ist;
die Farbschicht aus der Farbtinte durch eine Tintenstrahldruckmethode an einer Position entsprechend einem Anzeigepixelabschnitt an der Tintenfixierschicht (2) hergestellt ist.

## Revendications

1. Procédé de production d'un filtre de couleur (6) pour un affichage, comprenant la préparation d'un substrat transparent (1) ;
la formation d'une couche de fixation d'encre transparente (2) sur le substrat transparent (1) ;
l'impression à jet d'encre à une position arbitraire sur la couche de fixation d'encre (2) pour former une couche de couleur constituée d'une encre de couleur ;
dans lequel
le filtre de couleur (6) comprend
le substrat transparent (1),
la couche de fixation d'encre (2) formée sur au moins une surface du substrat transparent (1) et constituée d'une résine synthétique, et
la couche de couleur,
dans lequel le procédé de production d'un filtre de couleur (6) est **caractérisé en ce que**
l'encre de couleur contient 70 % ou plus d'un solvant ayant un point d'ébullition de 150 °C ou plus ; et que
la solubilité de la couche de fixation d'encre (2) dans le solvant est de 0,5 à 5 % ; dans lequel la solubilité de la couche de fixation d'encre (2) dans le solvant peut être mesurée après la formation de la couche de fixation d'encre (2).

2. Procédé de production d'un filtre de couleur (6) pour un affichage selon la revendication 1, **caractérisé en ce que** le solvant dans l'encre de couleur est composé d'au moins un solvant choisi parmi les esters aliphatiques, l'alcool polyhydrique et des dérivés de ceux-ci.

3. Procédé de production d'un filtre de couleur (6) pour un affichage selon la revendication 1, **caractérisé en ce que** l'angle de contact de la surface de la couche de fixation d'encre (2) sur le solvant dans l'encre de couleur est de 30° à 60°.

4. Procédé de production d'un filtre de couleur (6) pour un affichage selon la revendication 1, **caractérisé en ce que** le substrat transparent (1) est constitué en verre ou en un film de résine, et a sur celui-ci au moins deux marques d'alignement pour la structuration.

5. Procédé de production d'un filtre de couleur (6) pour un affichage selon la revendication 1, **caractérisé en ce que** :
le taux de transmission d'humidité du substrat transparent (1) est de 0,1 g/m²/24 heures ou moins ; et
le changement de dimension dans un traitement thermique à 100 °C pendant dix minutes est de 100 ppm ou moins.

6. Procédé de production d'un filtre de couleur (6) pour un affichage selon la revendication 1, **caractérisé en ce que** :
l'affichage est un affichage dans lequel un substrat permettant de former le filtre de couleur est préalablement fourni ;
la couche de fixation d'encre (2) est formée sur une surface d'affichage de l'affichage ;
la couche de couleur est constituée de l'encre de couleur par un procédé d'impression à jet d'encre à une position correspondant à une partie de pixel d'affichage sur la couche de fixation d'encre (2).
